# EUROPEAN PATENT SPECIFICATION

(11) **EP 2 895 839 B1**
(45) Date of publication and mention of the grant of the patent: **09.11.2016**
(21) Application number: 13785598.7
(22) Date of filing: 10.09.2013
(51) Int. Cl.: G01N 1/28

(54) **ELEMENT FOR MAKING REPLICAS IN MATERIAL SURFACE INVESTIGATIONS AND METHOD SUITED TO CARRY OUT SUCH INVESTIGATIONS**
ELEMENT ZUR HERSTELLUNG VON NACHBILDUNGEN BEI MATERIALOBERFLÄCHENPRÜFUNGEN UND VERFAHREN ZUR AUSFÜHRUNG DERARTIGER PRÜFUNGEN
ÉLÉMENT POUR RÉALISER DES RÉPLIQUES DANS DES INVESTIGATIONS DE SURFACE DE MATÉRIAU ET PROCÉDÉ APTE À EFFECTUER DE TELLES INVESTIGATIONS

(30) Priority: 13.09.2012 IT RM20120436; 22.10.2012 WO PCT/IT2012/000321
(43) Date of publication of application: 22.07.2015
(73) Proprietor: System Optimal Solution S.r.l., 70127 Bari (BA) (IT)
(72) Inventor: SASSANELLI, Michelangelo, I-70131 Bari (BA) (IT); D'OVIDIO, Francesco, Domenico, I-70127 Bari Santo Spirito (BA) (IT)
(74) Representative: Ziliotto, Tiziano
(86) International application number: PCT/IB2013/001978
(87) International publication number: WO 2014/041415

(56) References cited:
- WO-A1-2011/150316
- DE-C- 911 413
- US-A- 2 347 965
- US-A- 3 768 975
- US-A- 4 560 578
- US-A- 5 610 326
- US-A1- 2007 217 671
- US-A1- 2010 038 529

## Description

### TECHNICAL FIELD OF THE INVENTION

The present invention concerns the technical field of surface investigations on materials.

In particular, the present invention concerns the technical field of non-destructive surface investigations on materials.

More precisely, the invention concerns the technical field of the metallographic investigation carried out on the surfaces of metallic materials, commonly known as the replication method.

### DESCRIPTION OF THE STATE OF THE ART

Systems are generally known whose components are subjected to mechanical stress deriving from particular conditions of use, like for example high temperatures and/or high pressures.

According to the known technique, said components are periodically subjected to checks intended to assess their residual operating life.

Said checks are properly of the non-destructive type and are carried out on the surface of the component to be investigated.

A known investigation system is the replication method, an investigation technique used for metallographic investigations carried out "on the field", which is capable of making a copy of the microstructure of the metallic surface. The replication method is thus an investigation technique capable of carrying out a metallographic investigation on the components of a system with no need for destructive sampling. The investigation method through metallographic replication is used for assessing the microstructural condition of a component subjected to pressure and used in creep conditions.

The replication method consists, first of all, in placing an element in mutual contact with the properly prepared surface of the metallic component to be analysed, and successively in exerting a pressure on said element in order to impress the microstructure of the component being analysed on said element to a greater extent, thus obtaining the so-called "replica".

The successive examination of the replica with suitable instruments, for example a light optical microscope (LOM) or a scanning electron microscope (SEM), allows the morphological and cavitational assessment of the material, so that, using also other non-destructive investigation techniques, it is possible to determine the degree of damage due to creep.

A first known technique for making replicas makes use of an element constituted by a cellulose acetate plastic film.

This replication method requires first of all the preparation of a collection area on the surface of the metallic component to be analysed. The preparation of said area includes the following steps: slight surface abrasion of the component using abrasive paper with decreasing granulometry; successive polishing using diamond suspensions with decreasing granulometry; washing and finally chemical etching with a suitable solution.

After the chemical etching step, the collection area on the surface of the sample to be analysed is wetted with acetone. The acetate plastic film (element) is then positioned thereon, allowing a few minutes for it to dry up.

Then the acetate plastic film is removed from the collection area, thus obtaining the replica of the metallic sample to be analysed.

The replica is then placed on a microscope glass slide. Before the microscopic examination, with both an optical and an electron microscope, the acetate replicas are subjected to gold metallization.

A second known replication method makes use of a composite element in silicone-based resin.

The replica is obtained by placing a small quantity of the compound on the metallic surface, applying it by means of a dispenser gun with mechanical dosing/mixing unit. Then a support sheet, glossy on the side in contact with the resin, is placed on the compound. The support is useful when modelling the thickness of the resin, making it easier to spread it on the surface. After a suitable solidification time, the resin adhering to the support sheet is removed from the surface, thus obtaining the replica of the metallic sample to be analysed.

The replica is then placed on a microscope glass slide, making the side opposite the one that was in contact with the metallic surface adhere to said glass slide. The support sheet is fixed to the edges with adhesive tape, so that it is uniformly laid. The replica prepared in this way is ready for direct observation with an optical microscope, as its formulation contains finely dispersed metal powders capable of providing good contrast. The resin replicas for electron microscope observation are, as already mentioned, subjected to gold metallization.

Said metallization serves both the function of reducing the electrostatic charge effect on the surface of the replica and the function of dissipating the heat produced by the scanning operation, thus stabilizing the resin against the degrading effect of the microscope's electron beam. US5610326 and US3768975 show examples of elements for making surface replicas.

However, the replication methods of known type pose some drawbacks.

A first drawback of the known replication methods is constituted by the fact that the replicas show some limitations in the faithful reproduction of the microstructure of metal alloys.

Another drawback connected to the replication method with cellulose acetate is due to the fact that cellulose acetate sheets are difficult to use. Said sheets are difficult to apply, also because of the environmental conditions or of the scarce accessibility of the system component to which the sheet must be applied. Another drawback of the replication method with cellulose acetate lies in that it replicates only the surface topology of the sample to be analysed, thus showing only its macro defects.

Another drawback connected to the resin-based replication method lies in that it is not suitable for operation standardization.

A further drawback is constituted by the fact that it has a limited replication capacity, which determines a limitation for observation with advanced microscopy techniques. In fact, the so-called volume images of the replica, obtained with said technique, do not ensure sufficient image resolution and depth to obtain a microstructural detail that allows the required investigation to be carried out.

A further drawback connected to the replication method of the known type is constituted by the scarce planarity of the resin replica and by the fact that its thickness is not well defined, factors which make it difficult to obtain a completely in focus field during microscopic observation.

Another drawback connected to the replication method of the known type lies in that it allows only macro defects to be identified in the material being examined. The replication method of the known type does not allow, therefore, a detailed analysis of physical phenomena that would make it possible to foresee the occurrence of critical warning conditions, since it operates with excessively high dimensional scales and on physical phenomena that are not correlated with the involved microstructural evolution mechanisms.

Another drawback of the known technique is represented by the fact that the replication procedure is difficult to implement.

The main object of the present invention is therefore to at least partially solve the problems that characterize the known solutions and to propose an alternative method to said solutions.

In particular, it is one object of the present invention to provide an element suited to make an extraction replica of a surface of a material to be analysed, in which the characteristics of the surface to be analysed are duplicated and preserved with a microstructural detail level that is clearly higher compared to the replicas of the known type.

It is a further object of the present invention to provide an element suited to make an extraction replica of a surface of a material to be analysed in which the instrumental analysis shows higher resolution and sensitivity compared to the techniques of the known type.

### SUMMARY OF THE PRESENT INVENTION

The present invention is based on the general consideration that it is possible to obtain a surface extraction replica, that is, to extract some elements (precipitates) that are present or that form on the surface to be examined. The present invention is based on the further general consideration that a surface extraction replica of a material to be analysed can be effectively made using a material like indium or indium oxide that allows an extraction replica to be obtained.

According to a first aspect of the present invention, the subject of the same is, therefore, an element for making a surface extraction replica of a metallic material to be analysed or of elements made of a metallic material to be analysed, said element comprising a layer suited to be placed in contact with a surface area of said material to be analysed in order to memorize the characteristics of said material to be analysed, wherein said layer comprises indium or indium oxide. According to a further embodiment of the present invention, the layer comprises indium or indium oxide with a concentration of impurities that is lower than or equal to 15%, preferably lower than or equal to 10%, even more preferably lower than or equal to 5%.

According to a further embodiment of the present invention, the layer comprises indium with purity of at least 99%.

According to a further embodiment of the present invention, the layer comprises indium oxide with purity of at least 99%.

According to a further embodiment of the present invention, the layer comprises only indium (In) or indium oxide (In2O3) with the possible and/or inevitable impurities.

According to a further embodiment of the present invention, the layer comprises further chemical elements whose spectra do not overlap the spectra of the precipitates of the materials to be analysed.

According to a further embodiment of the present invention, the layer does not comprise tin. Some experiments, in fact, have shown that the presence of tin in the layer should preferably be avoided. In fact, the spectrum of tin is such as to at least partially overlap and/or at least partially alter the spectrum of the precipitates of the materials to be studied.

According to a further embodiment of the present invention, the layer further comprises one or more non-metallic chemical elements. In particular, the expression "non-metallic chemical elements" means the elements that, in the periodic table of elements, are not classified as metals. In this way, the emission lines of the spectrum of the materials making up the layer do not overlap the emission lines of the spectrum of the precipitates of the metallic material to be analysed.

In a preferred embodiment of the invention, the layer comprises a film in a metallic material.

The film is preferably flexible.

The element properly comprises also a layer supporting portion comprising indium or indium oxide.

The supporting portion preferably comprises a conductive material.

In a preferred embodiment of the invention the supporting portion comprises metallic materials, like for example aluminium.

In other embodiments of the invention the supporting portion comprises a conductive material, even non-metallic, like for example a conductive polymer. In further embodiments of the invention the supporting portion comprises a polymeric material.

Said supporting portion is preferably flexible.

Advantageously, in the extraction replica, surface elements of the material to be analysed, preferably precipitates, are extracted and adhere to the layer comprising indium or indium oxide.

Advantageously, the metallic material to be analysed comprises steel.

In particular, the metallic material preferably comprises:
- Ni and Co-based superalloys, from directional and monocrystalline solidification technologies, intermetallic alloys, thick and thin coatings (for example, PTA, HVOF, CVD/PVD), even of the ceramic type (for example, heat barriers);
- materials resistant to corrosion and oxidation at high and very high temperatures;
- materials resistant to creep, fatigue-creep, erosion wear, oxidation/corrosion, VHT etc;
- materials with high microstructural stability over time, even in transient conditions;
- Tig, Mig, plasma, laser, electronic beam, coated electrode, submerged arc, oxy acetylene welds etc;
- analyses of solutions suited to pass iterative material/component tests for reliability assessments;
- ceramic materials (refractory with high resistance to very high peak temperatures, etc), metallic-ceramic materials for special applications;
- cooling systems;
- special steels and alloys resistant to creep and fatigue-creep up to temperatures of 700/720°C (and above);
- materials resistant to hot oxidation/corrosion (for example, super austenitic materials, nickel alloys), both as "massive" solutions and as "multi-layer coatings" Coating Design;
- martensitic, ferritic, austenitic, austenitic-ferritic (duplex or super duplex) steels, hardening through precipitation;
- nickel-based, cobalt-based, iron-cobalt-based, iron-nickel-based, iridium-based superalloys, ODS superalloys;
- refractory and intermetallic ceramic materials like heat barriers and materials for reactor fuel components.

According to a second aspect of the present invention, the subject of the same is a kit comprising a casing and an element for making an extraction replica of the type described above, said casing being suited to create an environment protected from external agents that may damage or contaminate the layer of said element comprising indium or indium oxide.

According to a third aspect of the invention, the subject of the same is a method for making a surface extraction replica of a metallic material to be analysed or of elements made of a metallic material to be analysed, said method comprising a step in which an element is placed in contact with a surface area of said material to be analysed for the memorization of the microstructural characteristics of said material to be analysed and a step in which said element is removed, and wherein said element is an element according to the description provided above. According to a preferred embodiment of the invention, the method comprises a step in which the element is pressed against said surface area exerting a predetermined pressure.

Advantageously, during the step in which the element is placed in contact with the surface area of the material to be analysed, surface elements of the material to be analysed, preferably precipitates, are extracted and adhere to said layer comprising indium or indium oxide.

The method preferably comprises a preliminary step during which the surface area is prepared.

Advantageously, said preliminary step comprises at least one among the following operations: abrasion, polishing, cleaning through washing or chemical etching.

Preferably, the metallic material to be analysed comprises steel.

In particular, the metallic material preferably comprises:
- Ni and Co-based superalloys, from directional and monocrystalline solidification technologies, intermetallic alloys, thick and thin coatings (for example, PTA, HVOF, CVD/PVD), even of the ceramic type (for example, heat barriers);
- materials resistant to corrosion and oxidation at high and very high temperatures;
- materials resistant to creep, fatigue-creep, erosion wear, oxidation/corrosion, VHT etc;
- materials with high microstructural stability over time, even in transient conditions;
- Tig, Mig, plasma, laser, electronic beam, coated electrode, submerged arc, oxy acetylene welds etc;
- analyses of solutions suited to pass iterative material/component tests for reliability assessments;
- ceramic materials (refractory with high resistance to very high peak temperatures, etc), metallic-ceramic materials for special applications;
- cooling systems;
- special steels and alloys resistant to creep and fatigue-creep up to temperatures of 700/720°C (and above);
- materials resistant to hot oxidation/corrosion (for example, super austenitic materials, nickel alloys), both as "massive" solutions and as "multi-layer coatings" Coating Design;
- martensitic, ferritic, austenitic, austenitic-ferritic (duplex or super duplex) steels, hardening through precipitation;
- nickel-based, cobalt-based, iron-cobalt-based, iron-nickel-based, iridium-based superalloys, ODS superalloys;
- refractory and intermetallic ceramic materials like heat barriers and materials for reactor fuel components.

According to a further aspect of the present invention, the subject of the same is a method for analysing a surface extraction replica, comprising a step of making a surface extraction replica of a material to be analysed and a step of instrumental investigation of said surface extraction replica, wherein said surface extraction replica is obtained through the method previously described.

Preferably, the instrumental investigation step comprises at least one among the investigations included in the following group: optical microscope analysis, electron microscope analysis, diffractometer analysis.

According to another aspect of the invention, the subject of the same concerns the use of indium or indium oxide in a method for making a surface extraction replica of a metallic material to be analysed.

According to a further aspect, the present invention concerns the use of indium or indium oxide for the extraction and/or memorization of the macro or microstructural surface characteristics of a metallic material in a method for the surface investigation of a material to be analysed.

Indium preferably has a concentration of impurities lower than or equal to 15%, preferably lower than or equal to 10%, and even more preferably lower than or equal to 5%. Even more preferably, indium has purity of at least 99%.

Indium oxide preferably has a concentration of impurities lower than or equal to 15%, preferably lower than or equal to 10%, and even more preferably lower than or equal to 5%. Even more preferably, indium oxide has purity of at least 99%.

### BRIEF DESCRIPTION OF THE DRAWINGS

Further advantages, objects and characteristics, as well as further embodiments of the present invention are defined in the claims and will be illustrated in the following description, with reference to the enclosed drawings; in the drawings, corresponding or equivalent characteristics and/or components are identified by the same reference numbers. In particular:
- Figure 1 shows an element for making replicas in material surface investigations according to a preferred embodiment of the invention;
- Figures from 2 to 4 show some steps of the method for making a replica using the element shown in Figure 1 according to a preferred embodiment of the invention;
- Figure 5 shows a step of the method for analysing the replica obtained through the steps illustrated in the preceding figures from 2 to 4;
- Figures from 6 to 8 show some high-resolution images of the surface morphology and topology obtained through SEM investigation of an extraction replica made according to the method of the invention;
- Figures from 9 to 11 respectively show the spectra obtained through the detailed microanalysis of the extraction replica made according to the method of the invention using an EDS probe;

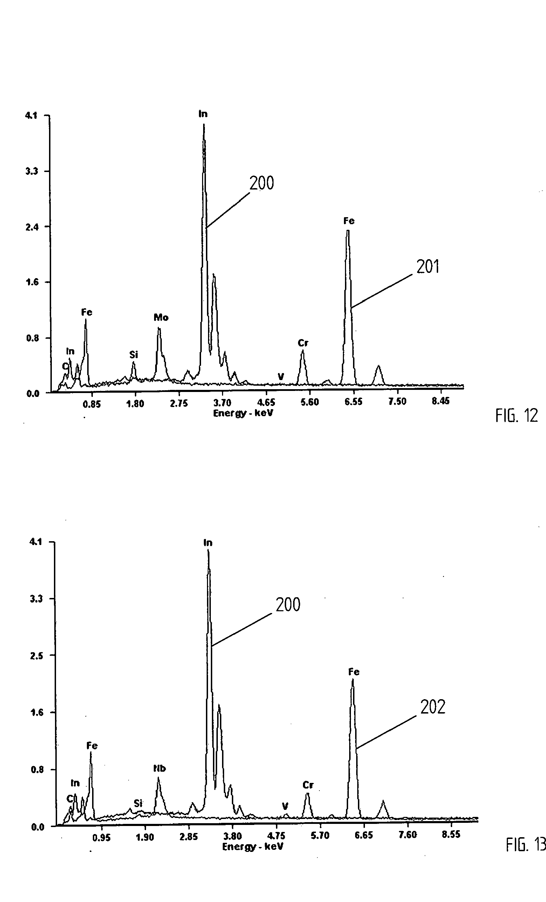

- Figures 12 and 13 respectively show the indium spectrum superimposed to the Laves phase spectrum and the indium spectrum superimposed to the Mx spectrum;

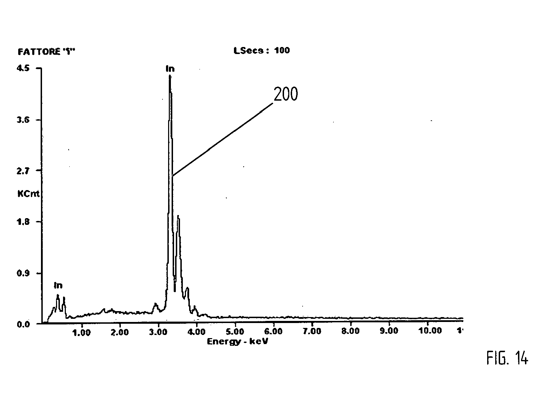

- Figure 14 shows the characteristic spectrum of indium.

### DETAILED DESCRIPTION OF THE PRESENT INVENTION

While the following description, made with reference to the figures, illustrates a particular embodiment of the present invention, it is clear that the present invention is not limited to said particular embodiment, rather, the individual embodiment described here below clarifies different aspects of the present invention, the scope and purpose of which are defined in the claims.

The present invention has shown to be particularly advantageous when applied to metallographic investigation carried out on the surfaces of metallic materials, more particularly steel, a technique that is known as replication method.

It should however be noted that the present invention is not limited to the metallographic investigation of surfaces of metallic materials. On the contrary, the present invention can be conveniently applied in all the situations in which it is necessary to investigate the surface of materials to assess their physical conditions and their useful life, for example:
- Ni and Co-based superalloys, from directional and monocrystalline solidification technologies, intermetallic alloys, thick and thin coatings (for example, PTA, HVOF, CVD/PVD), even of the ceramic type (for example, heat barriers);
- materials resistant to corrosion and oxidation at high and very high temperatures;
- materials resistant to creep, fatigue-creep, erosion wear, oxidation/corrosion, VHT etc;
- materials with high microstructural stability over time, even in transient conditions;
- Tig, Mig, plasma, laser, electronic beam, coated electrode, submerged arc, oxy acetylene welds etc;
- analyses of solutions suited to pass iterative material/component tests for reliability assessments;
- ceramic materials (refractory with high resistance to very high peak temperatures, etc), metallic-ceramic materials for special applications;
- cooling systems;
- special steels and alloys resistant to creep and fatigue-creep up to temperatures of 700/720°C (and above);
- materials resistant to hot oxidation/corrosion (for example, super austenitic materials, nickel alloys), both as "massive" solutions and as "multi-layer coatings" Coating Design;
- martensitic, ferritic, austenitic, austenitic-ferritic (duplex or super duplex) steels, hardening through precipitation;
- nickel-based, cobalt-based, iron-cobalt-based, iron-nickel-based, iridium-based superalloys, ODS superalloys;
- refractory and intermetallic ceramic materials like heat barriers and materials for reactor fuel components.

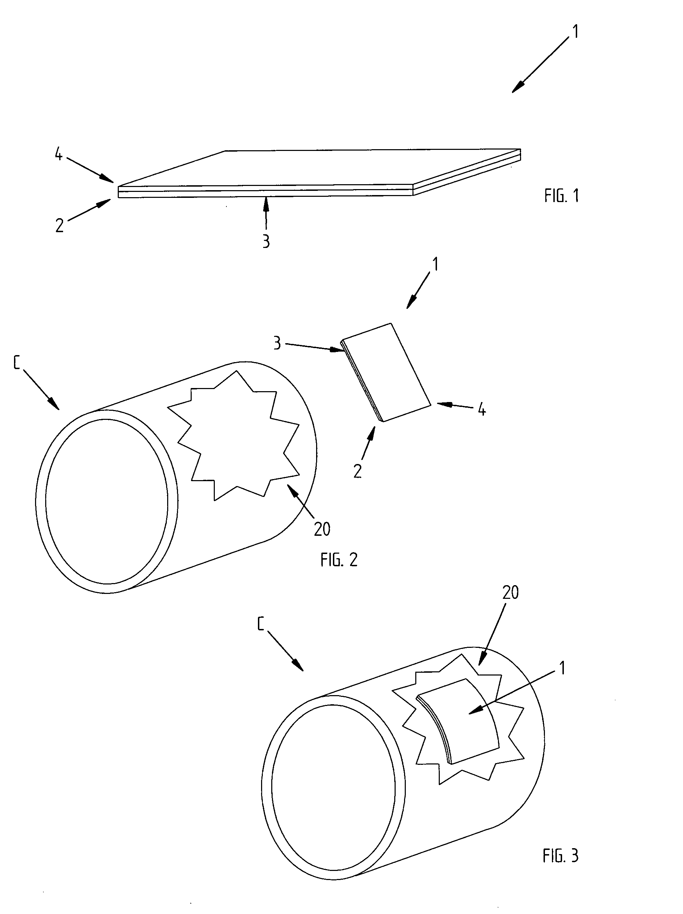

Figure 1 shows an element 1 for making a surface extraction replica of a material to be analysed, carried out according to a preferred embodiment of the present invention.

Figures from 2 to 4 show and illustrate the method of use of said element 1 to obtain a surface extraction replica 50 of the material to be analysed, according to a preferred embodiment of the invention.

The expression "surface extraction replica" means an element in which a copy, or replica, of the microstructure of the surface of the material to be analysed is made, said copy or replica being capable of highlighting both the topological characteristics and the microstructures, thus operating on high dimensional scales and on physical phenomena that can be correlated with microstructural evolution mechanisms.

The analysis of the extraction replica thus allows the assessment of the macro structural layer (analysis of grain boundaries, porosity, presence of defects, presence of microstructural phases: ferrite, martensite, bainite, inclusions) and of the fine microstructural layer (even deeper analysis, down to the resolution of the structure of metal, of dislocations, and to the fine dispersion of precipitates) of a component subjected to pressure and used in creep conditions, for the purpose of assessing its residual life.

According to the present invention, the element 1 preferably comprises a layer 2 comprising indium (In) or indium oxide (In203). The layer 2 preferably comprises indium (In) or indium oxide (In2O3), with a possible concentration of impurities lower than or equal to 10%. Indium (In) can have purity included between 90% and 100%. More particularly, indium (In) preferably has purity equal to or higher than 99%.

In some embodiments of the present invention, the layer 2 may comprise, in addition to indium (In) or indium oxide (In203), other material chemical elements whose spectra do not overlap the spectra of the precipitates of the materials, mainly metals, to be analysed. Preferably, the layer 2 may comprise, in addition to indium (In) or indium oxide (In203), one or more non-metallic chemical elements. In particular, the expression "non-metallic chemical elements" means the elements that, in the periodic table of elements, are not classified as metals.

Some experiments have shown, for example, that the presence of tin in the layer 2 should preferably be avoided. In fact, the spectrum of tin is such as to at least partially overlap and/or at least partially alter the spectrum of the precipitates of the materials to be studied.

In the preferred embodiment of the invention, the layer 2 preferably comprises a film of metallic material comprising indium (In) or indium oxide (In203). According to a further embodiment, the layer 2 comprises only indium (In) or indium oxide (In203) with the possible and/or inevitable impurities.

The layer 2 is preferably flexible, so that it can be deformed to facilitate its application to the surface of the material to be analysed, as is better described below.

The layer 2 is thus provided with a visible face 3 suited to be placed in contact with the surface of the material to be analysed.

Always according to the preferred embodiment of the invention, the layer 2 is associated with a supporting portion 4.

Said supporting portion 4 substantially has the same extension as the layer 2 and preferably comprises a layer of a conductive material, preferably a metallic material, like for example aluminium, copper etc. Even more preferably, said material is sufficiently rigid to bear the pressures necessary to obtain the extraction replica. In a further embodiment of the invention said layer can be made of a plastic material.

The supporting portion 4 is preferably flexible, so that it can be deformed to facilitate the application of the element 1 to the surface of the material to be analysed, as is better described below.

In variant embodiments of the invention, however, the supporting portion 4 can be made in a different way and comprise any material suited to serve as a support for the layer 2 comprising indium (In) or indium oxide (In203).

For example, the supporting portion 4 may comprises a layer of a conductive material, preferably a metallic material, like for example aluminium, copper etc. Even more preferably, said material is sufficiently rigid to bear the pressures necessary to obtain the extraction replica.

Preferably again, according to the preferred embodiment of the invention, the element 1 is associated with a casing having the shape of a capsule and suited to create a protected environment that surrounds the layer 2 with indium (In) or indium oxide (In203).

A first embodiment of the investigation method according to a preferred embodiment of the invention using the element 1 described above is illustrated here below with reference to Figures from 2 to 4.

The component to be analysed C is shown in the shape of a tube. Said component can be constituted, for example, by a critical component of a system, like an outlet tube belonging to a steam generator.

The material of the component C to be analysed is preferably constituted by steel, more precisely by steel of the martensitic, ferritic, austenitic, austenitic-ferritic (duplex or super duplex) type, hardening through precipitation.

In variant embodiments of the invention, however, the component to be analysed may be constituted by any other metallic material or, even more generally, comprise one of the materials indicated above.

In a first step of the investigation method according to the present invention an area 20 of the external surface of the component C is prepared.

The preparation of the surface area 20 can be carried out both manually and with the aid of suitable equipment, preferably portable equipment suited to be used on site on the component C to be analysed.

The preparation of the surface area 20 preferably includes a step of mechanical and/or electrochemical cleaning.

In this last case, the step must be performed paying particular attention to avoid damages to the surface to be analysed that may cause creep or porosity.

The preparation of the surface area 20 has the object of obtaining a surface with no deformations, cracks, defects and pits. Furthermore, said preparation serves to remove the elements that may affect negatively the examination of the microstructures and crystalline structures of the surface being investigated.

The preparation of the surface area 20 is preferably carried out using portable equipment provided with a revolving head with variable speed, on which it is possible to apply small discs of abrasive paper with decreasing granulometry. The same revolving head is also provided with polishing cloths, using diamond suspensions with decreasing granulometry. On each passage of the abrasive paper or the polishing cloths the surface is properly washed with alcohol and/or acetone. After the polishing operation, the surface area 20, hereinafter referred to as collection area 20, is preferably subjected to an etching process with an appropriate chemical solution, depending on the sample of material to be replicated.

In variant embodiments of the invention the preparation of the collection area 20 can be carried out in a different way and so as to prepare the surface for the successive step.

During said operations, the quality of the surface of the collection area 20 is preferably checked by means of a portable field microscope.

The preparation of the collection area 20, shown in Figure 2, is followed by a step in which the element 1 is applied to the collection area 20, as shown in Figure 3.

The element 1 is first taken from the capsule, if provided, where it is protected against external agents that may damage or contaminate it.

The element 1 is then applied with its visible surface 3 to the collection area 20. The characteristics of flexibility of the element 1 advantageously allow it to adapt to the non-planar shape of the external surface of the component C.

The element 1 is preferably applied to the collection area 20 by exerting a proper pressure on the element 1 itself.

The exerted pressure preferably depends on the type of material of which the sample is made.

Said pressure is preferably exerted on the supporting portion 4.

The application of said pressure makes it possible to obtain optimal planarity and therefore optimal surface as well as topological adherence of the element to the sample C. This thanks to the flexibility and/or plasticity of the supporting portion 4 that, once pressed, adapts to the shape of the surface of the sample C. The element 1 is thus modelled and assumes a shape that is topologically analogous to that of the collection area 20. In other words, the element 1, that is, the layer with indium 2 and the supporting portion 4, adapt to the shape and/or the surface characteristics of the component to be analysed.

It has been possible to verify that during the exertion of pressure the visible surface 3 of the layer with indium 2 is impressed, meaning that it memorizes and extracts the topological macro structure and the fine microstructure of the material of which the component C is made, thus obtaining the extraction replica 50 of the surface of the material to be analysed.

Thanks to the presence of indium (In) or indium oxide (In203) in the layer 2, the precipitates are advantageously extracted.

In fact, the ability of indium to extract the precipitates present on the sample to be examined has been demonstrated. More particularly, the precipitates are extracted from the sample (for example Laves, M23C6, Mx phases) and remain "attached" to indium. In other words, said precipitates are extracted from the sample C and, at least in some significant percentages, remain bonded/trapped/attached to the layer 2 with indium. For this reason, the type of replica that can be made with the method/element of the invention is called extraction replica.

The indium-based extraction replication offers further considerable advantages. In particular, thanks to:
- its exceptional chemical-physical (or mechanical) characteristics;
- its low melting point;
- its considerable softness and ductility (it can be scratched and impressed even at very low temperatures);
- its considerable plasticity (so much so that it can be indefinitely deformed through compression) and its wettability through simple cold pressure, which allows it to be bonded to metallic and non-metallic surfaces, like glass, ceramic etc,
indium makes it possible to obtain extraction replicas that allow deeper investigation to be carried out on the sample being examined.

Furthermore indium, being a semiconductor, advantageously makes it possible to avoid the replica metallization step. In fact, the samples that must be examined under SEM in order to determine their morphology and microstructure need to be positioned and treated properly. In the replication techniques of the known type the sample, if it is not conductive by nature, as in the example described above, must be made conductive at least in its surface layer, by covering it with a thin gold layer (coating or metallization). The surface coating, for example with gold, of the replicas of known type makes it almost impossible to observe high-resolution images of the fine microstructure (for example: Laves, M23C6, Mx phases), or images with correlation to the elementary composition of the surface, or to perform a semi-quantitative chemical analysis of the sample, as the emission spectra that are typical of the surface materials used for metallization overlap the typical spectra of the elements making up the microstructure of the sample (for example, the precipitates). It should also be noted that indium, in addition to being a semi conductor with well-defined chemical-physical characteristics, has a spectrum that does not overlap the emission spectrum lines of the precipitates, as will be better explained further on in this description. This advantageously makes it possible to carry out SEM-EDS or XRD investigations that are much more effective compared to the replication techniques of the known type, and are thus able to identify also fine microstructural details. These and other chemical-physical characteristics make indium a material that can be used to achieve the objects of the present invention, in fact it makes it possible to implement the new extraction replication method and to provide an element for making replicas as described in the present application.

Thanks to the above mentioned advantageous characteristics of indium, it has thus been surprisingly proved that indium is particularly suited to be used for making extraction replicas.

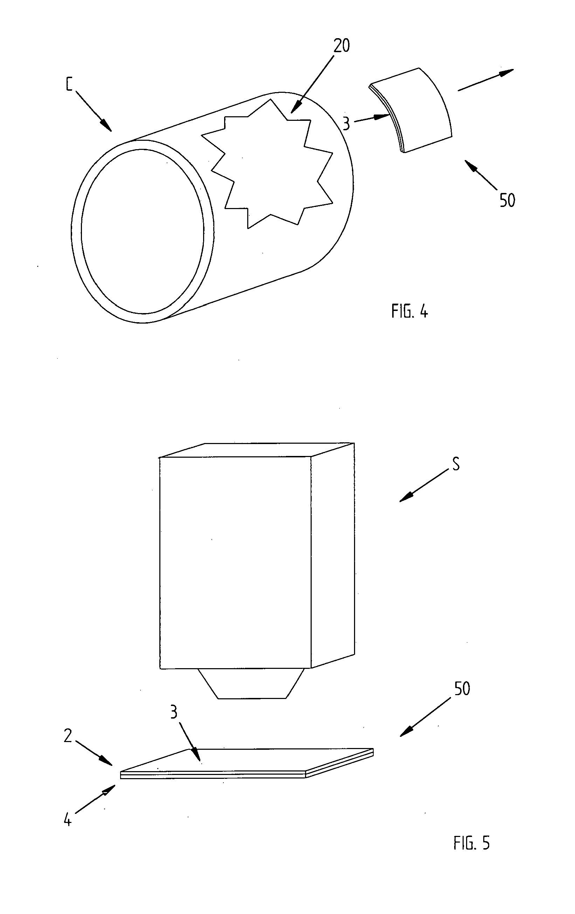

After pressure has been exerted for a suitable time interval, the replica 50 is removed from the collection area 20, as shown in Figure 4.

The removal is preferably carried out taking care to perform a regular movement. The replica 50 is then preferably encapsulated.

The replica 50 prepared in this way is ready to be observed directly with suitable equipment S, as schematically shown in Figure 5.

In a first embodiment of the invention, the replica 50 is subjected to investigation with an optical microscope.

Optical microscope investigation makes it possible to observe and determine the dimensions of the grains of the sample subjected to analysis and their dimensional homogeneity, their degree of work hardening and recrystallization, as well as to detect the presence of compounds of precipitations on the grain boundary, of cracks, porosity or damage, the presence of different phases (for example Laves phases, obviously within the limits of the optical resolution of the optical microscope), as well as the presence and extent of corrosion phenomena. Advantageously, the observation of the replica 50 according to the invention offers higher resolution and sensitivity compared to the observations made using replicas according to the known techniques.

In a different embodiment of the invention, the replica 50 is subjected to investigation with an electron microscope.

In this case, advantageously, the replica 50 does not need any metallization process since, as previously explained, the extraction replica proposed herein is already conductive by nature, at ambient temperature.

This makes it possible to avoid a preparation step in the investigation, differently from the known techniques, thus simplifying the investigation process itself and making it more rapid and economical.

By means of said investigation, still advantageously, the extraction replica according to the invention allows the fine microstructure of the replicated sample to be examined, to the extent that it is possible to detect different types of precipitates with a high degree of precision, for example: M23C6, Mx, Laves phases, Z phases, precipitation classes by average size, chemical composition of the precipitate, nucleation and growth of "new" Laves phases (presently not detectable with the traditional replication method).

Still advantageously, SEM-EBSD, SEM-EDS or XRD examination of the replica according to the invention makes it possible to highlight the dimensional distribution of Laves, M23C6 and Mx phases (with average diameter varying from 20 to 40 nm for Mx phases and from 200 to 300 micron for Laves phases), detecting a high density of precipitate dislocations in the sample of material under examination (for example, steel).

Advantageously, the observation of the replica 50 according to the invention offers higher resolution and sensitivity compared to the observations made using replicas according to the known techniques.

In a further embodiment of the invention the replica 50 is subjected to investigation with diffractometer.

In a preferred embodiment of the invention, the indium-based (In) or indium oxide-based (In2O3) element comprises a supporting portion (constituted by a disc with predetermined shape and size generally made of a metal or polymer-based material) on which a thin layer of indium (In) or indium oxide (In203), just a few millimetres thick, is housed. In order to prevent any damage to the support with indium (In) or indium oxide (In2O3), the whole is housed inside capsules (or cartridges). The indium-based (In) or indium oxide-based (In2O3) element is positioned on the surface of the sample or device to be analysed, exerting a suitable pressure for the time interval (approximately 10-30 seconds) necessary to obtain the metallographic replication of the surface being examined. Before carrying out said procedure, the surfaces of the sample are prepared following a standard procedure (for example according to the UNI reference standards) and then etched with acid solutions of various types depending on the material to be investigated (for example according to the UNI reference standards). Said extraction replication method is thus carried out by placing the surface to be analysed in mutual contact with the layer comprising indium (In) or indium oxide (In203).

The layer 2 preferably comprises indium (In) or indium oxide (In203), with a possible concentration of impurities lower than or equal to 10%. Indium (In) can have purity included between 90% and 100%. More particularly, indium (In) preferably has purity of 99%.

In some embodiments of the present invention, the layer 2 may comprise, in addition to indium (In) or indium oxide (In2O3), other chemical elements whose spectra do not overlap the spectra of the precipitates of the materials, mainly metals, to be analysed. Preferably, the layer 2 may comprise, in addition to indium (In) or indium oxide (In2O3), one or more non-metallic chemical elements. In particular, the expression "non-metallic chemical elements" means the elements that, in the periodic table of elements, are not classified as metals. Some experiments have shown, for example, that the presence of tin in the layer 2 should preferably be avoided. In fact, the spectrum of tin is such as to at least partially overlap and/or at least partially alter the spectrum of the precipitates of the materials to be studied.

According to a further embodiment, the layer 2 comprises only indium (In) or indium oxide (In2O3) with the possible and/or inevitable impurities.

The extraction replication method applied in this way makes it possible to obtain optimal surface planarity (which is difficult to obtain with the replication methods using acetate film and silicone or polymer-based resin) as well as to ensure correct and equal distribution of the pressures in proximity to the contact surfaces, thanks to the aid of the supporting portion which facilitates the modelling operation (meaning that it allows the thickness of the layer comprising indium (In) or indium oxide (In2O3) to be kept constant and uniform, so as to avoid having replica portions with different thicknesses) thus completing and ensuring the correct surface and topologic distribution of indium or indium oxide on the sample or device being examined.

Once pressure has been exerted for a suitable time interval, indicatively of 10-30 seconds, the supporting portion with the layer comprising indium (In) or indium oxide (In2O3) is detached from the surface of the sample and/or device to be analysed, taking care to perform a linear and regular movement. The extraction replica obtained in this way is re-incapsulated. The extraction replica obtained in this way does not need any other preparation operation, thus allowing direct observation with LM, FE-SEM, SEM-EBSD, XRD, or any other analysis device. Advantageously, the replica according to the invention faithfully reproduces the microstructure of the material, so much so that it cannot be distinguished from the original metallographic surface: LOM examination makes it possible to monitor the macro and microstructural layer of the material with a high degree of reliability, while electron microscope investigation (SEM-EBSD) makes it possible to study the fine microstructure of the sample exactly as if it were a metallographic sample.

Still advantageously, the extraction replica according to the invention makes it possible to examine the fine microstructure of the replicated sample, so much so that it can detect with a high degree of precision different types of precipitates, for example: M23C6, Mx, Laves phases, Z phases, precipitation classes by average size, chemical composition of the precipitate, nucleation and growth of "new" Laves phases (presently not detectable with the traditional replication method).

Still advantageously, SEM-EBSD examination of the replica according to the invention makes it possible to highlight the dimensional distribution of Laves, M23C6 and Mx phases (with average diameter varying from 20 to 40 nm for Mx phases and from 200 to 300 micron for Laves phases), detecting a high density of precipitate dislocations in the sample of the material under examination (for example, steel). The results obtained with EBSD have been achieved with 0.15 micron pitch at 20Kv, operating distance 19 mm, opening at 120 micron, current probe between 0.1 and 1 nA, the maps have been obtained with backscattered electrons (BSE); Laves phases enriched with Mo, Vn, Nb are clearly visible (formation of subgrains).

Finally, precipitates of type M23C6 mainly positioned on the boundary have been clearly observed, also small quantities of Mx have been detected, finely distributed in the solid solution of the matrix.

The extraction replication method according to the invention advantageously makes it possible to obtain a high degree of information thanks to the reproducibility of the macro structure and in particular of the microstructure (as this is where the microstructural evolution of the material being examined can be observed). Furthermore, said extraction replication method makes it possible to use different instrumental analysis technologies that cannot be used in the techniques of known type (due to scarce information and to the limited chemical-physical characteristics of the replicas made using the methods available today, for example replication with cellulose acetate film or polymer resin, as widely explained above).

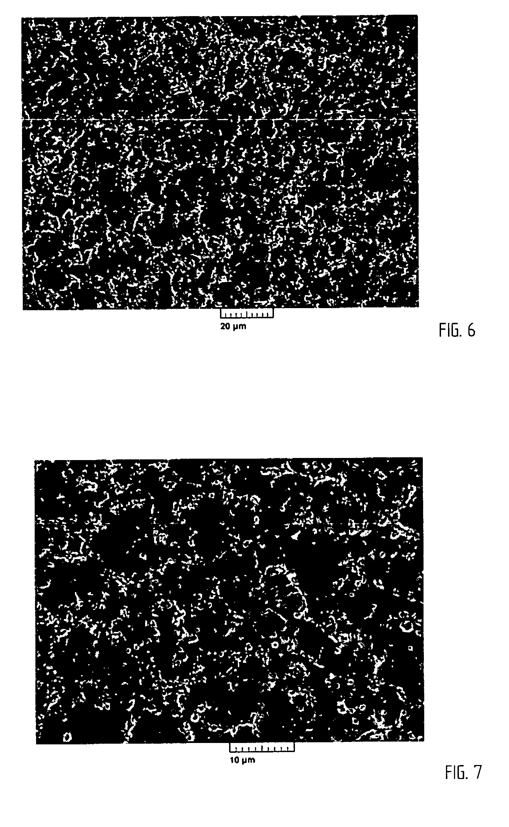

By way of example, Figures 6, 7 and 8 show high resolution images of the surface morphology and topology of a sample of martensitic steel, degree P91, obtained during SEM examination with different magnifying powers of an extraction replica obtained according to the invention.

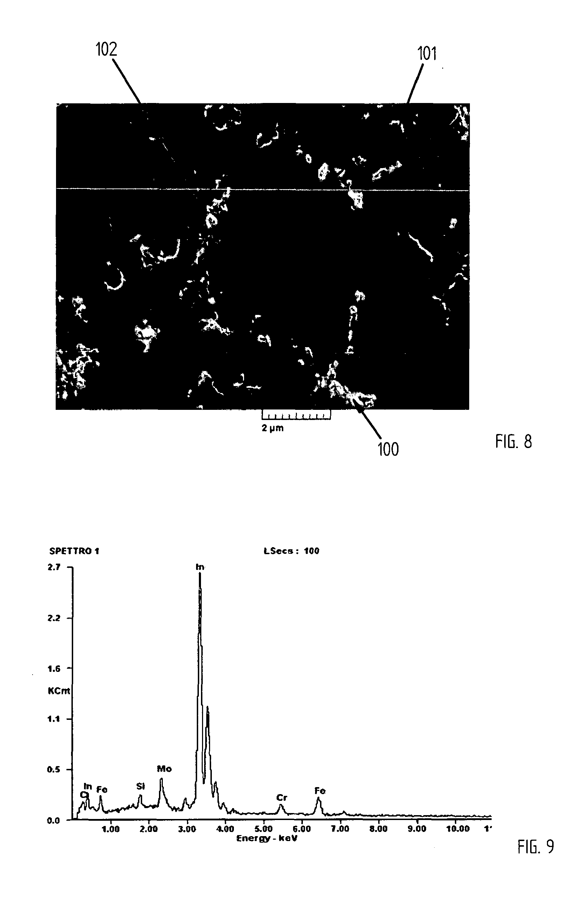

In particular, Figure 6 shows a SEM image with 20µm (2000x) magnifying power, while Figures 7 and 8 respectively show two SEM images of the same extraction replica with different magnifying powers, respectively 20µm (5000x) and 2µm (25000x).

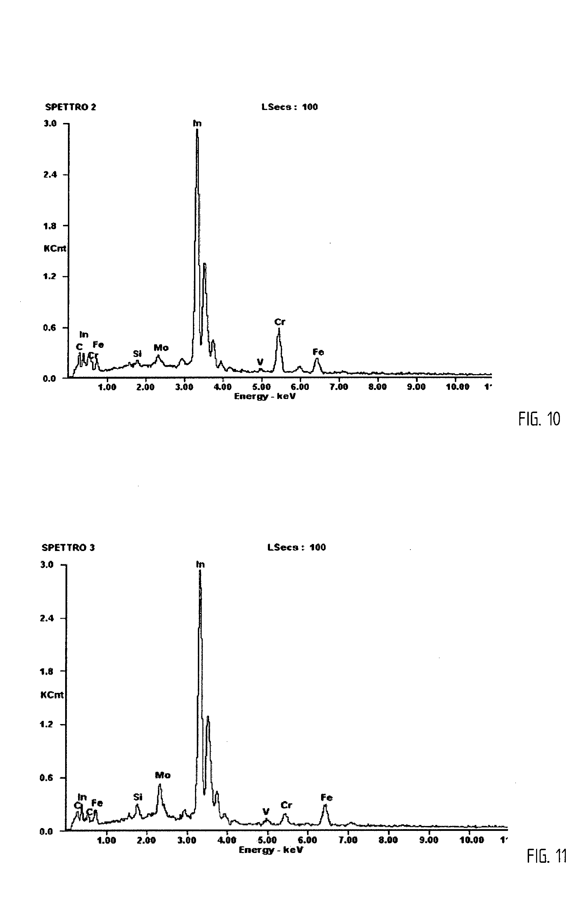

Said images make it possible to highlight how the extraction replica obtained according to the invention allows the macro and microstructure of the sample subjected to analysis to be examined in detail. In particular, Figure 8 shows microstructural details that are finely distributed on the grain boundary, like Laves phases (indicated by 100 in the Figure), M23C6+Mx phases (indicated by 101 in the Figure), and finally Laves+Mx phases (indicated by 102 in the figure). Figures 9, 10 and 11 respectively show the spectra obtained through fine semi-quantitative chemical analysis (microanalysis) of the sample with the EDS probe, with which it is possible to obtain spectra to identify the elementary composition of the sample and maps of the element distribution. In particular, therefore, Figures 9, 10 and 11 show the spectra obtained on different specific positions of the extraction replica, previously indicated in Figure 8 respectively by 100 (Laves phases), 101 (M23C6 + Mx phases) and 102 (Laves+Mx phases). Figure 12 shows the spectrum of indium (indicated by 200) overlapping the spectrum of the Laves phase (indicated by 201) obtained on sample with matrix effect.

Analogously, Figure 13 shows the spectrum of indium (indicated by 200) overlapping the spectrum of the Mx phase (indicated by 202), also obtained on sample with matrix effect.

By way of example, the characteristic spectrum of indium only is shown in Figure 14.

Said spectra clearly show that the characteristic peaks of the indium spectrum substantially do not overlap the characteristic peaks of the spectra of Laves, M23C6 and Mx phases, respectively. Therefore, this makes it possible to obtain an analysis of the extraction replica obtained according to the contents of the present patent application that is not altered by the spectrum of the matrix of the material of which the element 1 is made.

The above clearly shows that, always according to the present invention, it is also possible to deduct the characteristic spectrum of the extraction replica (indium) from the characteristic spectrum of the components (Laves, M23C6, Mx phases...) that make up the sample being examined.

The above has thus shown that the present invention allows all the set objects to be achieved. In particular, it makes it possible to provide an element that is suitable for making an extraction replica of a surface of a material to be analysed, wherein the result of the successive observation is qualitatively and quantitatively much better than the results obtained with the techniques of known type.

While the present invention has been described with reference to the particular embodiments shown in the figures, it should be noted that the present invention is not limited to the specific embodiment illustrated and described herein; on the contrary, further variants of the embodiment described herein fall within the scope of the present invention, scope which is defined in the claims.

## Claims

1. Element (1) for making a surface extraction replica (50) of a metallic material to be analysed (C), said element (1) comprising a layer (2) suited to be placed in contact with a surface area (20) of said material to be analysed (C) so as to memorize the characteristics of said material to be analysed (C), **characterized in that** said layer (2) comprises indium (In) or indium oxide (In203).

2. Element (1) according to claim 1, **characterized in that** said layer (2) comprises indium (In) or indium oxide (In203) with a concentration of impurities that is lower than or equal to 15%, preferably lower than or equal to 10%, even more preferably lower than or equal to 5%.

3. Element (1) according to claim 2, **characterized in that** said layer comprises indium (In) or indium oxide (In203) with purity of at least 99%.

4. Element (1) according to any of the preceding claims, **characterized in that** said layer (2) comprises only indium (In) or indium oxide (In203) with the possible and/or inevitable impurities.

5. Element (1) according to any of the claims from 1 to 3, **characterized in that** the layer (2) further comprises chemical elements whose spectra do not overlap the spectra of the precipitates of the material to be analysed.

6. Element (1) according to claim 1, 2, 3 or 5, **characterized in that** the layer (2) further comprises one or more non-metallic chemical elements.

7. Element (1) according to any of the preceding claims, **characterized in that** said layer (2) comprises a film in a metallic material.

8. Element (1) according to any of the preceding claims, **characterized in that** said film is flexible.

9. Element (1) according to any of the preceding claims, **characterized in that** it also comprises a supporting portion (4) for said layer (2).

10. Element (1) according to claim 9, **characterized in that** said supporting portion (4) comprises a conductive material.

11. Element (1) according to claim 9 or 10, **characterized in that** said supporting portion (4) is flexible.

12. Element (1) according to any of the preceding claims, **characterized in that** in said extraction replica (50) surface elements of said material to be analysed (C), preferably precipitates, are extracted and adhere to said layer (2) comprising indium (In) or indium oxide (In203).

13. Element (1) according to any of the preceding claims, **characterized in that** said metallic material comprises steel.

14. Kit comprising a casing and an element for making an extraction replica, **characterized in that** said element (1) is an element (1) according to any of the claims from 1 to 13, said casing being suited to create an environment protected against external agents that may damage or contaminate said layer (2) comprising indium (In) or indium oxide (In203) of said element (1).

15. Method for making a surface extraction replica (50) of a metallic material to be analysed (C), said method comprising a step of positioning an element (1) in contact with a surface area (20) of said material to be analysed (C) so as to memorize the characteristics of said material to be analysed (C) and a step of removal of said element (1), **characterized in that** said element (1) is an element (1) according to any of the claims from 1 to 13.

16. Method according to claim 15, **characterized in that** it comprises a step during which said element (1) is pressed against said surface area (20) exerting a pre-determined pressure.

17. Method according to claim 15 or 16, **characterized in that** during said step of positioning of said element (1) in contact with said surface area (20) of said material to be analysed (C), surface elements of said material to be analysed (C), preferably precipitates, are extracted and adhere to said layer (2) comprising indium (In) or indium oxide (In203).

18. Method according to any of the claims from 15 to 17, **characterized in that** it comprises a preliminary step during which said surface area (20) is prepared.

19. Method according to claim 18, **characterized in that** said preliminary step comprises at least one among the operations belonging to the group including the following steps: abrasion, polishing, cleaning through washing or chemical etching.

20. Method according to any of the claims from 15 to 19, **characterized in that** said metallic material comprises steel.

21. Method for analysing a surface extraction replica (50), comprising a step of making a surface extraction replica (50) from a material to be analysed (C) and a step of investigating said surface extraction replica (50) with instruments, **characterized in that** said surface extraction replica (50) is obtained by means of the method according to any of the claims from 15 to 20.

22. Method according to claim 21, **characterized in that** said investigation step carried out with instruments comprises at least one among the investigations included in the following group: optical microscope analysis, electron microscope analysis, diffractometer analysis.

23. Use of indium (In) or indium oxide (In203) in a method for making a surface extraction replica (50) of a metallic material to be analysed (C).

24. Use of indium (In) or indium oxide (In203) to memorize the surface characteristics of a metallic material in a method for investigating the surface of a material to be analysed (C).

25. Use according to claim 23 or 24, **wherein** indium (In) or indium oxide (In203) has a concentration of impurities equal to or lower than 15%, preferably equal to or lower than 10%, even more preferably equal to or lower than 5%.

26. Use according to claim 25, **wherein** indium (In) or indium oxide (In203) has purity of at least 99%.

## Patentansprüche

1. Element (1) zur Herstellung eines Oberflächenextraktions-Replikats (50) eines zu analysierenden, metallischen Materials (C), wobei das besagte Element (1) eine Schicht (2) umfasst, welche geeignet ist, in Kontakt mit einem Oberflächenbereich (20) des besagten, zu analysierenden Materials (C) positioniert zu werden, um die Merkmale des besagten, zu analysierenden Materials (C) zu speichern, **dadurch gekennzeichnet, dass** die besagte Schicht (2) Indium (In) oder Indiumoxid (In203) enthält.

2. Element (1) gemäß Patentanspruch 1, **dadurch gekennzeichnet, dass** die besagte Schicht (2) Indium (In) oder Indiumoxid (In203) mit einer Konzentration an Verunreinigungen enthält, die geringer als oder gleich 15 %, vorzugsweise geringer als oder gleich 10 %, und noch bevorzugter geringer als oder gleich 5 % ist.

3. Element (I) gemäß Patentanspruch 2, **dadurch gekennzeichnet, dass** die besagte Schicht Indium (In) oder Indiumoxid (In203) mit einer Reinheit von wenigstens 99 % enthält.

4. Element (1) gemäß eines jeden der vorstehenden Patentansprüche, **dadurch gekennzeichnet, dass** die besagte Schicht (2) nur Indium (In) oder Indiumoxid (In203) mit den möglichen und/oder unvermeidbaren Verunreinigungen enthält.

5. Element (1) gemäß eines jeden der Patentansprüche von 1 bis 3, **dadurch gekennzeichnet, dass** die Schicht (2) des Weiteren chemische Elemente umfasst, deren Spektren die Spektren der Ausfällungen des zu analysierenden Materials nicht überlappen.

6. Element (1) gemäß Patentanspruch 1, 2, 3 oder 5, **dadurch gekennzeichnet, dass** die Schicht (2) des Weiteren ein oder mehrere nichtmetallische chemische Elemente umfasst.

7. Element (1) gemäß eines jeden der vorstehenden Patentansprüche, **dadurch gekennzeichnet, dass** die besagte Schicht (2) einen Film aus metallischem Material umfasst.

8. Element (1) gemäß eines jeden der vorstehenden Patentansprüche, **dadurch gekennzeichnet, dass** der besagte Film flexibel ist.

9. Element (1) gemäß eines jeden der vorstehenden Patentansprüche, **dadurch gekennzeichnet, dass** es auch einen tragenden Abschnitt (4) für die besagte Schicht (2) umfasst.

10. Element (1) gemäß Patentanspruch 9, **dadurch gekennzeichnet, dass** der besagte, tragende Abschnitt (4) ein leitfähiges Material umfasst.

11. Element (1) gemäß Patentanspruch 9 oder 10, **dadurch gekennzeichnet, dass** der besagte, tragende Abschnitt (4) flexibel ist.

12. Element (1) gemäß eines jeden der vorstehenden Patentansprüche, **dadurch gekennzeichnet, dass** in dem besagten Extraktionsreplikat (50) Oberflächenelemente des besagten, zu analysierenden Materials (C), vorzugsweise Ausfällungen, extrahiert werden und an der besagten, Indium (In) oder Indiumoxid (In203) enthaltenden Schicht (2) anhaften.

13. Element (1) gemäß eines jeden der vorstehenden Patentansprüche, **dadurch gekennzeichnet, dass** das besagte, metallische Material Stahl umfasst.

14. Satz, ein Gehäuse und ein Element zur Herstellung eines Extraktionsreplikats umfassend, **dadurch gekennzeichnet, dass** das besagte Element (1) ein Element (1) gemäß eines jeden der Patentansprüche von 1 bis 13 ist, wobei das besagte Gehäuse dazu geeignet ist, eine gegen externe Einwirkungen, die die besagte, Indium (In) oder Indiumoxid (In203) enthaltende Schicht (2) des besagten Elements (1) beschädigen oder kontaminieren können, geschützte Umgebung zu schaffen.

15. Verfahren zur Herstellung eines Oberflächenextraktions-Replikats (50) eines zu analysierenden, metallischen Materials (C), wobei das besagte Verfahren einen Schritt der Positionierung eines Elements (1) in Kontakt mit einem Oberflächenbereich (20) aus dem zu analysierenden Material (C) umfasst, um die Merkmale des besagten, zu analysierenden Materials (C) zu speichern, sowie einen Schritt der Entfernung des besagten Elements (1) umfasst, **dadurch gekennzeichnet, dass** das besagte Element (1) ein Element (1) gemäß eines jeden der Patentansprüche von 1 bis 13 ist.

16. Verfahren gemäß Patentanspruch 15, **dadurch gekennzeichnet, dass** es einen Schritt umfasst, während dessen das besagte Element (1) unter Ausübung eines vorbestimmten Drucks gegen den besagten Oberflächenbereich (20) gepresst wird.

17. Verfahren gemäß Patentanspruch 15 oder 16, **dadurch gekennzeichnet, dass** während des besagten Schritts der Positionierung des besagten Elements (1) in Kontakt mit dem besagten Oberflächenbereich (20) des besagten, zu analysierenden Materials (C), Oberflächenelemente, vorzugsweise Ausfällungen, extrahiert werden und an der besagten, Indium (In) oder Indiumoxid (In203) enthaltenden Schicht (2) anhaften.

18. Verfahren gemäß eines jeden der Patentansprüche von 15 bis 17, **dadurch gekennzeichnet, dass** es einen vorausgehenden Schritt umfasst, während dessen der besagte Oberflächenbereich (20) vorbereitet wird.

19. Verfahren gemäß Patentanspruch 18, **dadurch gekennzeichnet, dass** der besagte, vorausgehende Schritt wenigstens einen Vorgang aus der Gruppe umfasst, die folgende Schritte umfasst: Abschleifen, Polieren, Reinigen durch Waschen oder chemisches Ätzen.

20. Verfahren gemäß eines jeden der Patentansprüche von 15 bis 19, **dadurch gekennzeichnet, dass** das besagte, metallische Material Stahl umfasst.

21. Verfahren zur Analyse eines Oberflächenextraktions-Replikats (50), einen Schritt der Herstellung eines Oberflächenextraktions-Replikats (50) aus einem zu analysierenden Material (C) und einen Schritt der Untersuchung des besagten Oberflächenextraktions-Replikats (50) mit Instrumenten umfassend, **dadurch gekennzeichnet, dass** das Oberflächenextraktions-Replikat (50) mittels des Verfahrens gemäß eines jeden der Patentansprüche von 15 bis 20 gewonnen wird.

22. Verfahren gemäß Patentanspruch 21, **dadurch gekennzeichnet, dass** der besagte, mit Instrumenten ausgeführte Schritt der Untersuchung wenigstens eine der in der folgenden Gruppe enthaltenen Untersuchungen umfasst: Analyse mit optischem Mikroskop, Analyse mit Elektronenmikroskop, Analyse mit Diffraktometer.

23. Verwendung von Indium (In) oder Indiumoxid (In203) in einem Verfahren zur Herstellung eines Oberflächenextraktions-Replikats (50) eines zu analysierenden, metallischen Materials (C).

24. Verwendung von Indium (In) oder Indiumoxid (In203) zur Speicherung der Oberflächenmerkmale eines metallischen Materials (C) in einem Verfahren zur Untersuchung der Oberfläche eines zu analysierenden Materials (C).

25. Verwendung gemäß Patentanspruch 23 oder 24, **wobei** das Indium (In) oder Indiumoxid (In203) eine Konzentration an Verunreinigungen enthält, die geringer als oder gleich 15 %, vorzugsweise geringer als oder gleich 10 %, und noch bevorzugter geringer als oder gleich 5 % ist.

26. Verwendung gemäß Patentanspruch 25, **wobei** das Indium (In) oder Indiumoxid (In203) eine Reinheit von wenigstens 99 % aufweist.

## Revendications

1. Élément (1) pour la réalisation d'une réplique d'extraction de surface(50) d'un matériau métallique à analyser (C), ledit élément (1) comprenant une couche (2) apte à être mise en contact avec une zone de surface(20) dudit matériau à analyser (C) de façon à mémoriserles caractéristiques dudit matériau à analyser (C), **caractérisé en ce que** ladite couche (2) comprend de l'indium (In) ou de l'oxyde d'indium (In2O3).

2. Élément (1) selon la revendication 1, **caractérisé en ce que** ladite couche (2) comprend de l'indium (In) ou de l'oxyde d'indium (In2O3) avec une concentration d'impuretés de 15% ou inférieure, préférablement de 10% ou inférieure, encore plus préférablement de 5% ouinférieure.

3. Élément (1) selon la revendication 2, **caractérisé en ce que** ladite couche comprend de l'indium (In) ou de l'oxyde d'indium (In2O3) avec une pureté d'au moins 99%.

4. Élément (1) selon l'une quelconque des revendications précédentes, **caractérisé en ce que** ladite couche (2) comprend uniquement de l'indium (In) ou de l'oxyde d'indium (In2O3) avec les impuretés éventuelles et/ou inévitables.

5. Élément (1) selon l'une quelconque des revendications de 1 à 3, **caractérisé en ce que** la couche (2) comprenden outre des éléments chimiques ayant des spectres qui ne se superposent pas aux spectres des précipités du matériau à analyser.

6. Élément (1) selon l'une des revendications 1, 2, 3 ou 5, **caractérisé en ce que** la couche (2) comprenden outre un ou plusieurs éléments chimiques non métalliques.

7. Élément (1) selon l'une quelconque des revendications précédentes, **caractérisé en ce que** ladite couche (2) comprend une pellicule en matériau métallique.

8. Élément (1) selon l'une quelconque des revendications précédentes, **caractérisé en ce que** ladite pellicule est flexible.

9. Élément (1) selon l'une quelconque des revendications précédentes, **caractérisé en ce qu**'il comprend en plus une portion de support (4) pour ladite couche (2).

10. Élément (1) selon la revendication 9, **caractérisé en ce que** ladite portion de support (4) comprend un matériau conducteur.

11. Élément (1) selon la revendication 9 ou 10, **caractérisé en ce que** ladite portion de support (4) est flexible.

12. Élément (1) selon l'une quelconque des revendications précédentes, **caractérisé en ce que** dans ladite réplique d'extraction (50) des éléments de surface dudit matériau à analyser (C), préférablement précipités, sont extraits et adhèrent à ladite couche (2) comprenant de l'indium (In) ou de l'oxyde d'indium (In2O3).

13. Élément (1) selon l'une quelconque des revendications, **caractérisé en ce que** ledit matériau métallique comprend de l'acier.

14. Kit comprenant un boîtier et un élément pour la réalisation d'une réplique d'extraction, **caractérisé en ce que** ledit élément (1) est un élément (1) selon l'une quelconque des revendications de 1 à 13, ledit boîtier étant apte à créer un milieu protégé des agents extérieurs qui pourraient endommager ou contaminer ladite couche (2) comprenant de l'indium (In) ou de l'oxyde d'indium (In2O3) dudit élément (1).

15. Méthode pour réaliser une réplique d'extraction de surface (50) d'un matériau métallique à analyser (C), ladite méthode comprenant une phase de positionnement d'un élément (1) en contact avec une zone de surface (20) dudit matériau à analyser (C) de façon à mémoriserles caractéristiques dudit matériau à analyser (C) et une phase d'enlèvement dudit élément (1), **caractérisée en ce que** ledit élément (1) est un élément (1) selon l'une quelconque des revendications de 1 à 13.

16. Méthode selon la revendication 15, **caractérisée en ce qu**'elle comprend une phase durant laquelle ledit élément (1) est pressé contre ladite zone de surface (20) en exerçant une pression prédéterminée.

17. Méthode selon la revendication 15 ou 16, **caractérisée en ce que** durant ladite phase de positionnement dudit élément (1) en contact avec ladite zone de surface(20) dudit matériau à analyser (C), des éléments de surface dudit matériau à analyser (C), préférablement des précipités, sont extraits et adhèrent à ladite couche (2) comprenant de l'indium (In) ou de l'oxyde d'indium (In2O3).

18. Méthode selon l'une quelconque des revendications de 15 à 17, **caractérisé en ce qu**'elle comprend une phase préliminaire de préparation de ladite zone de surface(20).

19. Méthode selon la revendication 18, **caractérisée en ce que** ladite phase préliminaire comprend au moins une parmi les opérations appartenant au groupe comprenant les phases de: abrasion, polissage, nettoyage par lavage ou attaque chimique.

20. Méthode selon l'une quelconque des revendications de 15 à 19, **caractérisée en ce que** ledit matériau métallique comprend de l'acier.

21. Méthode pour l'analyse d'une réplique d'extraction de surface (50) comprenant une phase de réalisation d'une réplique d'extraction de surface (50) d'un matériau à analyser (C) et une phase d'examen exécutée avec des instruments de ladite réplique d'extraction de surface (50), **caractérisée en ce que** ladite réplique d'extraction de surface (50) est obtenue au moyen de la méthode selon l'une quelconque des revendications de 15 à 20.

22. Méthode selon la revendication 21, **caractérisée en ce que** ladite phase d'examen exécutée avec des instruments comprend au moins un parmi les examens compris dans le groupe suivant: analyse au microscope optique, analyse au microscope électronique, analyse au diffractomètre.

23. Utilisation de l'indium (In) ou del'oxyde d'indium (In2O3) dans une méthode pour réaliser une réplique d'extraction de surface(50) d'un matériau métallique à analyser (C).

24. Utilisation de l'indium (In) ou de l'oxyde d'indium (In2O3) pour la mémorisation des caractéristiques de surface d'un matériau métallique dans une méthode d'examen de la surface d'un matériau à analyser (C).

25. Utilisation selon la revendication 23 ou 24, **où** l'indium (In) ou l'oxyde d'indium (In2O3) a une concentration d'impuretés de 15% ou inférieure,préférablement de 10% ou inférieure, encore plus préférablement de 5% ou inférieure.

26. Utilisation selon la revendication 25, **où** l'indium (In) ou l'oxyde d'indium (In2O3) a une pureté d'au moins 99%.
